# EUROPÄISCHE PATENTANMELDUNG

(11) **EP 4 764 028 A1**
(43) Veröffentlichungstag der Anmeldung: **24.06.2026**
(21) Anmeldenummer: 25219093.9
(22) Anmeldetag: 27.11.2025
(51) Int. Cl.: C23C 16/04, C23C 16/455, C23C 16/54, B05D 7/22

(54) **VERFAHREN ZUM BESCHICHTEN VON BEHÄLTERN SOWIE BEHÄLTERBESCHICHTUNGSANLAGE**

(30) Priorität: 12.12.2024 DE 102024137409
(71) Anmelder: KHS GmbH, 44143 Dortmund (DE)
(72) Erfinder: Herbort, Michael, 44143 Dortmund (DE)
(74) Vertreter: Andrejewski - Honke Patent- und Rechtsanwälte Partnerschaft mbB

(57) **Zusammenfassung**

Die Erfindung betrifft ein Verfahren zum Beschichten von Behältern (1) mit mehreren jeweils zumindest einen Behälter (1) aufnehmenden Beschichtungsstationen (3), wobei den Beschichtungsstationen (3) in einem Beschichtungsbetrieb in einer zeitlichen Abfolge in zueinander versetzen ersten Zuführintervallen ein erstes Prozessfluid zugeführt wird. Erfindungsgemäß ist vorgesehen, dass das erste Prozessfluid zur Vergleichmäßigung eines Gesamtstroms in ersten Ausgleichsintervallen (13) zumindest teilweise parallel zu den Beschichtungsstationen (3) von einer ersten Zuführung (Z₁) durch einen ersten Bypass (B₁) zu einer Abführung geleitet wird. Gegenstand der Erfindung ist auch eine Behälterbeschichtungsanlage.

## Beschreibung

Die Erfindung betrifft ein Verfahren zum Beschichten von Behältern mit mehreren jeweils zumindest einen Behälter aufnehmenden Beschichtungsstationen, wobei den Beschichtungsstationen in einem Beschichtungsbetrieb in einer zeitlichen Abfolge in zueinander versetzten ersten Zuführintervallen ein erstes Prozessfluid zugeführt wird. Die Behälter sind insbesondere Behälter aus Kunststoff, besonders bevorzugt Kunststoffflaschen. Bei dem nachfolgend weiter erläuterten Verfahren werden üblicherweise zusätzlich zu dem ersten Prozessfluid weitere, davon verschiedene Prozessfluide zugeführt, wobei die im Rahmen der Erfindung vorgesehenen Maßnahmen für mehrere Prozessfluide und vorzugsweise alle Prozessfluide vorgesehen sein können.

In der Getränkeindustrie oder auch für andere flüssige oder pastöse Produkte, wie beispielsweise Reinigungsmittel oder Kosmetika, werden in der Praxis Kunststoffbehälter und insbesondere Kunststoffflaschen eingesetzt. Weit verbreitet sind Flaschen aus PET (Polyethylenterephthalat), welche sich durch gute Funktionseigenschaften einschließlich einer guten Recyclingfähigkeit auszeichnet.

Obwohl PET im Vergleich zu vielen anderen Kunststoffen bereits gute Barriereeigenschaften aufweist, besteht bei empfindlichen Produkten oder besonders hohen Qualitätsanforderungen das Bedürfnis, die Barriereeigenschaften weiter zu verbessern. Hierzu ist es bekannt, die Behälterwand mit einer inneren Barriereschicht zu versehen. Hierzu können dünne Schichten aus Kohlenwasserstoffverbindungen oder dünne quarzglasähnliche Schichten insbesondere auf der Basis von SiOₓ vorgesehen sein. (s. "Blasformen von Kunststoffkörpern", zweite, aktualisierte Auflage 2022, Michael Thielen, Klaus Hartwig, Peter Gust, ISBN 978-3-446-45552-8, Seiten 211 bis 213).

Entsprechende Vorrichtungen und Verfahren sind auch in der EP 3 433 395 B1, der DE 102 25 609 A1 und der WO 03/100120 A2 beschrieben.

Die Abscheidung zumindest einer dünnen Schicht erfolgt durch einen Plasmaverfahren, wobei dazu häufig unterschiedliche Druckstufen vorgesehen sein können. Insbesondere kann auch eine oberflächliche Reinigung oder Aktivierung vorgesehen sein, bevor die Beschichtung aufgebracht wird. Auch die Erzeugung mehrerer Schichten in unmittelbar aufeinander folgenden Schritten ist dabei möglich. Dabei ist auch zu berücksichtigen, dass als Prozessfluide eingeleitete Gase und/oder trotz einer Druckreduzierung verbleibende Luft durch den Plasmaprozess aktiviert werden können, wodurch reaktive Gase bzw. reaktive Gasbestandteile gebildet werden. Als reaktive Bestandteile können insbesondere Sauerstoff, Ozon und Sauerstoffionen vorhanden sein.

Um eine Massenfertigung zu ermöglichen, werden Behälterbeschichtungsanlagen eingesetzt, die um den Umfang eines Trägerrades eine Vielzahl von Beschichtungsstationen aufweisen. Die Beschichtungsstationen können dabei für die Aufnahme eines Behälters oder vorzugsweise mehrerer Behälter eingerichtet sein, wobei die gesamte Beschichtung während der Rotation der Beschichtungsstationen zwischen einer Zuführposition und einer Abführposition der als Getränkeflaschen ausgestalteten Behälter kontinuierlich erfolgt. Um für den Beschichtungsprozess unterschiedliche Druckniveaus in einem Vakuumbereich und/oder unterschiedliche Fluide bereitzustellen und abzuführen, weisen die Beschichtungsstationen jeweils eine Ventilanordnung mit mehreren Ventilen auf, die an entsprechende Druckreservoirs bzw. Fluidreservoirs angeschlossen sind.

Die Funktion einer bekannten Behälterschichtungsanlage ist auch in dem Video "KHS InnoPET Plasmax 12D", https://youtu.be/tYbr6B5CHhk dargestellt.

Bei aus dem Stand der Technik bekannten Plasmaabscheidungsprozessen ist bezogen auf das Beschichten der einzelnen Behälter in der Regel ein mehrstufiger Prozess vorgesehen. Mehrere Stufen können beispielsweise vorgesehen sein, um die zu beschichtende Oberfläche durch eine Plasmabehandlung zu aktivieren, eine Art Haftvermittlerschicht zu bilden, eine oder mehrere Barriereschichten zu erzeugen oder auch Zwischenschichten zu bilden. Dabei ist es üblich, für die einzelnen Schritte unterschiedliche, in der Regel gasförmige Prozessfluide zuzuführen. Insbesondere können unterschiedliche Gasgemische als Prozessfluide vorgesehen sein, um in dem Plasmaprozess die gewünschte chemische Zusammensetzung und darauf basierende die vorgesehene Oberflächenbehandlung zu erreichen.

Die Bereitstellung unterschiedlicher Prozessfluide ist dem Fachmann bekannt, wozu auf die EP 4 417 730 A1 verwiesen wird.

Im Rahmen der Erfindung ist vorgesehen, dass den Beschichtungsstationen in dem Beschichtungsbetrieb in einer zeitlichen Abfolge in zueinander versetzten ersten Zuführintervallen ein erstes Prozessfluid zugeführt wird. Dabei ist es üblich, die Beschichtungsstationen in dem Beschichtungsbetrieb in wiederkehrenden Arbeitszyklen zu betreiben.

Da das erste Prozessfluid mit einem zeitlichen Versatz den Beschichtungsstationen zugeführt wird, wird stets nur ein Teil der Beschichtungsstationen mit dem ersten Prozessfluid beaufschlagt. Dabei ist es auch üblich, dass durch den zeitlichen Versatz der Fortschritt des Beschichtungsprozesses bei jeder Beschichtungsstation anders ist.

Um dann in der Summe einen gleichmäßigen Fluss des ersten Prozessfluids zu erreichen, werden in der Praxis während des Beschichtungsbetriebs eine gleiche Anzahl an Beschichtungsstationen mit dem ersten Prozessfluid beaufschlagt. Beispielsweise kann vorgesehen sein, dass stets genau eine Beschichtungsstation, genau zwei Beschichtungsstationen, genau drei Beschichtungsstationen usw. mit dem ersten Prozessfluid versorgt werden. Wenn dann die Zufuhr des ersten Prozessfluids zu einer Beschichtungsstation beendet wird, wird gleichzeitig eine weitere Beschichtungsstation hinzugeschaltet.

Entsprechende Maßnahmen sind in der Praxis auch für die übrigen Prozessfluide vorgesehen, die dann für andere Arbeitsschritte den Beschichtungsstationen zugeführt werden.

Bei üblichen Behälterbeschichtungsanlagen sind die Beschichtungsstationen an einer gemeinsamen umlaufenden Traganordnung, insbesondere einem Trägerrad angeordnet. Ein solches Trägerrad wird aufgrund seiner Funktion auch als Beschichtungsrad bezeichnet. Ein Umlauf der Traganordnung, also insbesondere des Trägerrades, entspricht dann üblicherweise einem vollständigen Beschichtungsprozess, wobei die Behälter an einem Übergabebereich aufgenommen, nachfolgend in mehreren Schritten konditioniert und beschichtet sowie an dem Übergabebereich wieder abgegeben werden.

Unter Berücksichtigung der Anzahl der Beschichtungsstationen ergibt sich dann eine Winkelteilung, welche für die Aufteilung des Prozesses in mehrere Schritte genutzt werden kann. Bei einer großen Anzahl an Beschichtungsstationen ergibt sich dann eine entsprechend feine Winkelteilung, sodass dann die Schritte auf der Basis einer solchen Winkelteilung vergleichsweise frei mit einer unterschiedlichen Länge definiert werden können. Die Länge der einzelnen Prozessschritte bezogen auf den Umfangswinkel kann dann als ein Vielfaches der Winkelteilung definiert werden.

Wie bereits zuvor erläutert, gelten die entsprechenden Überlegungen ohne Einschränkung auch für die Zuführung weiterer Prozessfluide, wobei auch dazu üblicherweise ein gleichmäßiger Durchfluss bereitgestellt werden soll.

Bei einer geringeren Anzahl an Beschichtungsstationen ergibt sich somit eine eingeschränkte Flexibilität. Um einen gleichmäßigen Fluss des ersten Prozessfluids oder gegebenenfalls auch weiterer Prozessfluide zu ermöglichen, bedarf es dann auch zu dem entsprechenden Prozessschritt einer minimalen Länge bezogen auf den zurückgelegten Winkel, die nicht unterschritten werden kann.

Der vorliegenden Erfindung liegt die Aufgabe zugrunde, bei einem Verfahren zum Beschichten von Behältern die Flexibilität zu erhöhen. Des Weiteren soll eine entsprechende Behälterbeschichtungsanlage angegeben werden.

Gegenstand der Erfindung und Lösung der Aufgabe sind ein Verfahren zum Beschichten von Behältern gemäß Patentanspruch 1 sowie eine Behälterbeschichtungsanlage gemäß Patentanspruch 7.

Ausgehend von einem eingangs beschriebenen Verfahren ist demnach erfindungsgemäß vorgesehen, dass das erste Prozessfluid zur Vergleichmäßigung eines Gesamtstromes in ersten Ausgleichsintervallen parallel zu den Beschichtungsstationen von einer ersten Zuführung durch einen ersten Bypass zu einer Abführung geleitet wird. Um einen gleichmäßigen Strom des ersten Prozessfluids zu erreichen, muss im Rahmen der Erfindung der Gesamtstrom nicht wie in dem Stand der Technik auf eine gleiche Anzahl von Beschichtungsstationen verteilt sein.

Wenn im Rahmen des gesamten Verfahrensablaufs zeitweise eine Beschichtungsstation weniger mit dem ersten Prozessfluid beaufschlagt wird, kann das erste Prozessfluid auch über den ersten Bypass abgeleitet werden. Ohne die Bereitstellung des ersten Bypasses würden ansonsten Druckschwankungen resultieren, welche eine gleichmäßige Verfahrensführung behindern könnten. Insbesondere könnte sich an zumindest einer weiteren Beschichtungsstation, zu der das erste Prozessfluid parallel zugeführt wird, eine unerwünschte Druckerhöhung ergeben.

Gemäß einer bevorzugten Ausgestaltung der Erfindung ist vorgesehen, dass die Beschichtungsstationen in dem Beschichtungsbetrieb in wiederkehrenden Arbeitszyklen betrieben werden, wobei in ersten Teilzyklen n Beschichtungsstationen und während der dazwischen vorgesehenen ersten Ausgleichsintervalle n-1 Beschichtungsstationen das erste Prozessfluid zugeführt wird.

Werden in den ersten Teilzyklen n = 1, 2, 3, 4, ... Beschichtungsstationen mit dem ersten Prozessfluid versorgt, wird das erste Prozessfluid bei den ersten Ausgleichsintervallen n-1 = 0, 1, 2, 3, ... Beschichtungsstationen zugeleitet. Der Wegfall einer Beschichtungsstation wird dann durch das Öffnen des ersten Bypasses ausgeglichen, wodurch sich ein gleichmäßiger Gesamtstrom ergibt.

Wie bereits zuvor erläutert, wird bei dem gesamten Beschichtungsprozess üblicherweise mit mehreren Prozessfluide gearbeitet, wobei dann auch für die weiteren Prozessfluide jeweils ein entsprechender Bypass vorgesehen sein kann, um auch dort in der beschriebenen Weise den Gesamtstrom des jeweiligen Prozessfluids konstant zu halten.

So kann Beispielsfalls vorgesehen sein, dass den Beschichtungsstationen in dem Beschichtungsbetrieb zusätzlich in einer zeitlichen Abfolge in zueinander versetzten zweiten Zuführintervallen ein zweites Prozessfluid zugeführt wird, wobei das zweite Prozessfluid zur Vergleichmäßigung eines Gesamtstroms in zweiten Ausgleichsintervallen parallel zu den Beschichtungsstationen von einer zweiten Zuführung durch einen zweiten Bypass zu der Abführung oder einer zweiten Abführung geleitet wird. Dabei kann dann analog zu dem zuvor beschriebenen ersten Prozessfluid vorgesehen sein, dass in zweiten Teilzyklen m Beschichtungsstationen und während der dazwischen vorgesehenen zweiten Ausgleichsintervalle m-1 Beschichtungsstationen das zweite Prozessfluid zugeführt wird.

In gleicher Weise können auch für weitere Prozessfluide, beispielsweise ein drittes Prozessfluid und ein viertes Prozessfluid, ein jeweils zugeordneter Bypass, also insbesondere ein dritter Bypass und ein vierter Bypass, vorgesehen sein.

Durch entsprechende Maßnahmen können dann die Zeiten für die einzelnen Schritte in dem Beschichtungsprozess sehr frei gewählt und bei Bedarf angepasst werden.

Dabei versteht sich auch, dass der Durchfluss durch den jeweiligen Bypass an den Durchfluss jeweils einer Beschichtungsstation angepasst ist. Bei den üblichen Schaltschemata variiert die Anzahl der gleichzeitig versorgten Beschichtungsstationen üblicherweise um den Wert 1, wobei die Erfindung aber grundsätzlich nicht auf diese besonders bevorzugte Ausgestaltung beschränkt ist und gegebenenfalls auch unterschiedliche Schaltstufen des Bypasses denkbar sind, um die durch zwei oder mehr Beschichtungsstationen geleitete Menge des jeweiligen Prozessfluids parallel ableiten zu können. Vor dem Hintergrund einer möglichst einfachen und effizienten Verfahrensführung ist eine solche Weiterbildung aber nicht bevorzugt und bei üblichen Anwendungsfällen auch nicht notwendig.

Im Rahmen der Erfindung ist vorgesehen, dass die Behälter durch einen Plasmaabscheidungsprozess beschichtet werden, wozu auch auf den eingangs diskutierten Stand der Technik verwiesen wird. Des Weiteren kann durch einen Plasmaprozess auch eine Konditionierung der zu beschichtenden Fläche erfolgen.

Bei dem Plasmaabscheide- oder Plasmakonditionierungsprozess wird das Plasma vorzugsweise mittels Mikrowellen erzeugt, wobei dann ein Aufnahmeraum innerhalb der Beschichtungsstationen ein Resonator bildet.

Gegenstand der Erfindung ist auch eine Behälterbeschichtungsanlage, die insbesondere zur Durchführung des zuvor beschriebenen Verfahrens geeignet und vorgesehen ist.

Die Behälterbeschichtungsanlage umfasst mehrere Beschichtungsstationen zur Aufnahme von jeweils zumindest einem Behälter, eine erste Zuführung für ein erstes Prozessfluid, an welche die Beschichtungsstationen angeschlossen sind, einen steuerbaren ersten Bypass von der ersten Zuführleitung zu einer Abführung und eine Anlagensteuerung, wobei die Anlagensteuerung dazu eingerichtet ist, in einem Beschichtungsbetrieb das erste Prozessfluid in ersten Ausgleichsintervallen parallel zu den Beschichtungsstationen von der ersten Zuführung durch den ersten Bypass zu der Abführung zu leiten.

Wie zuvor beschrieben, kann dadurch eine Vergleichmäßigung eines Gesamtstroms des ersten Prozessfluids erreicht werden.

Wie im Zusammenhang mit dem Verfahren beschrieben, können in gleicher Weise ein zweiter Bypass für ein zweites Prozessfluid, ein dritter Bypass für ein drittes Prozessfluid, ein vierter Bypass für ein viertes Prozessfluid usw. vorgesehen sein.

Gemäß einer bevorzugten Ausgestaltung der Erfindung sind die Beschichtungsstationen an einer umlaufenden Traganordnung angeordnet. Die Traganordnung kann als Trägerrad ausgestaltet sein, welches dann aufgrund seiner Funktion in der Praxis auch als Beschichtungsrad bezeichnet wird. Grundsätzlich sind aber auch andere umlaufende Traganordnungen wie beispielsweise umlaufende Ketten denkbar.

Die umlaufende Traganordnung ist bevorzugt an eine feststehende Anlagenbaugruppe angeschlossen. Die feststehende Anlagenbaugruppe kann dabei zumindest eine an die Abführung angeschlossene Vakuumpumpstufe und zumindest ein erstes an die erste Zuführung angeschlossenes Fluidaufbereitungsmodul aufweisen. Als Prozessfluid kann insbesondere ein reaktives Gas vorgesehen sein, welches zur Erzeugung einer Beschichtung auf der Basis von SIOₓ Hexamethyldisiloxan (HMDSO) enthält.

Gemäß einer bevorzugten Ausgestaltung der Erfindung ist der erste Bypass an der Traganordnung angeordnet und wird dann zusammen mit den Beschichtungsstationen bewegt. Es ergibt sich dann der Vorteil, dass der Einfluss negativer dynamischer Effekte bei der Steuerung des ersten Prozessfluids aufgrund von längeren Leitungen oder dergleichen vermieden Betriebsphase reduziert werden können.

Ein optional vorgesehener zweiter Bypass und gegebenenfalls weitere zuvor beschriebene Bypässe sind vorzugsweise in gleicher Weise an der Traganordnung vorgesehen.

Insbesondere kann ein Bypassmodul mit dem zumindest ersten Bypass und gegebenenfalls weiteren Bypässen gebildet sein. Das Bypassmodul kann dann separat zu den Beschichtungsstationen angeordnet sein, insbesondere an der Traganordnung.

Wie bereits zuvor in Bezug auf das Verfahren erläutert, soll der erste Bypass so ausgestaltet sein, dass im geöffneten Zustand der Durchsatzes und der daraus resultierenden Druck bzw. Druckabfall den Bedingungen an einer der Beschichtungsstationen entspricht. Hierzu kann vorgesehen sein, dass der erste Bypass ein Schaltventil und ein Drosselelement aufweist, um den gewünschten Durchfluss bereitstellen zu können.

Das Drosselelement kann dabei eine Blende, eine Verengung oder dergleichen sein. Das Drosselelement kann dabei verstellbar oder unverstellbar ausgeführt sein. Durch ein verstellbares Drosselelement, beispielsweise in Form eines Drosselventils, kann eine Justierung erfolgen, wobei auch gegebenenfalls eine Anpassung an unterschiedliche Verfahrensrezepte möglich ist, bei denen auch der Durchfluss des ersten Prozessfluids durch die Beschichtungsstationen verändert wird.

Es versteht sich, dass für das optional vorgesehene zweite Prozessfluid, dritte Prozessfluid, vierte Prozessfluid usw. entsprechend ein zweiter Bypass, ein dritter Bypass, ein vierter Bypass usw. bereitgestellt werden können, wobei diese dann zweckmäßigerweise auch mit einem Schaltventil und einem Drosselelement ausgestaltet sein können.

Gemäß der vorliegenden Erfindung wird ein erhöhter Verbrauch des ersten Prozessfluids und gegebenenfalls weiterer Prozessfluide in Kauf genommen, weil diese bei einer Führung durch den entsprechenden Bypass zumindest teilweise ungenutzt bleiben.

Dagegen ergeben sich die Vorteile, dass die Prozessabläufe und insbesondere die Intervalle für die Zuführung des ersten Prozessfluids und gegebenenfalls weiterer Prozessfluide freier nach den jeweiligen Erfordernissen ausgewählt und optimiert werden können. Es ist insbesondere einfacher, als Rezepte bezeichnete Prozessparameter und -einstellungen zwischen Maschinen mit einer gleichen Umlaufgeschwindigkeit zu übertragen. Auch auf Änderungen der Dauer des Beschichtungsprozesses kann dann besser reagiert werden. Insbesondere kann auch darauf Rücksicht genommen werden, wenn lediglich ein Teil der Schritte schneller durchgeführt werden kann, sodass sich dann im Verhältnis der Schritte zueinander Veränderungen ergeben.

Bei einer Behälterbeschichtungsanlage mit einer großen Zahl an Beschichtungsstationen ergibt sich durch die Anzahl ein relativ feines Raster an Variationsmöglichkeiten, um auch ohne die Bereitstellung des Bypasses stets eine gleiche Anzahl an Beschichtungsstationen mit dem ersten Prozessfluid oder einem weiteren Prozessfluid zu beaufschlagen. Auch dann kann aber im Rahmen der Erfindung eine weitere Flexibilisierung ermöglicht werden.

Besonders zum Tragen kommen die erfindungsgemäßen Vorteile jedoch bei Behälterbeschichtungsanlagen, welche insgesamt eine vergleichsweise geringe Zahl an Beschichtungsstationen, beispielsweise zwischen 8 und 20 Beschichtungsstationen, aufweisen. Insbesondere können 12 Beschichtungsstationen vorgesehen sein, die in dem Beschichtungsbetrieb zyklisch betrieben werden.

Die Beschichtungsstationen können jeweils für die Aufnahme mehrerer Behälter, insbesondere zwei bis vier Behälter eingerichtet sein. Bei einer Behälterbeschichtungsanlage mit exemplarisch zwölf Beschichtungsstationen und einer jeweiligen Aufnahmekapazität der Beschichtungsstationen von vier Behältern ergeben sich also um den Umfang der Traganordnung 48 Aufnahmeplätze für Behälter.

Die Erfindung wird nachfolgend anhand von Ausführungsbeispielen näher erläutert. Es zeigen:
- Fig. 1: eine schematische Ansicht einer Behälterbeschichtungsanlage für Getränkeflaschen,
- Fig. 2: eine Beschichtungsstation der Behälterbeschichtungsanlage gemäß Fig. 1,
- Fig. 3: ein schematisches Prozessdiagramm gemäß dem Stand der Technik für zehn Beschichtungsstationen,
- Fig. 4: ein erfindungsgemäßes Prozessdiagramm für zehn Beschichtungsstationen,
- Fig. 5: ein Anlagenschaubild eines Teils einer Behälterbeschichtungsanlage.

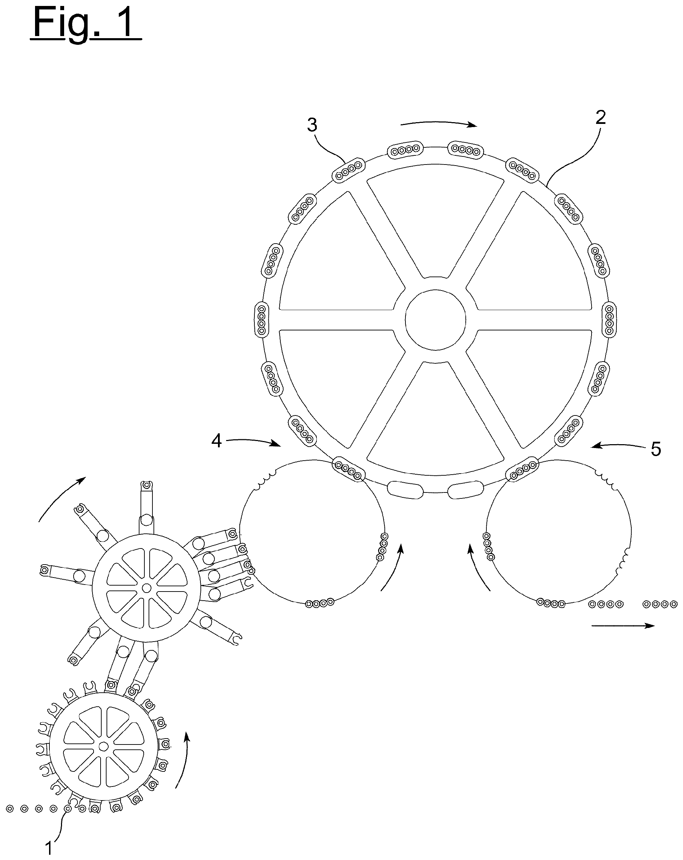

Die Fig. 1 zeigt eine Behälterbeschichtungsanlage zum Beschichten von Behältern 1 in Form von PET-Getränkeflaschen, die kontinuierlich zugeführt werden. Die Behälterbeschichtungsanlage weist eine umlaufende Traganordnung in Form eines rotierbaren Trägerrades 2 mit daran angeordneten Beschichtungsstationen 3 auf.

Die Beschichtungsstationen 3 sind jeweils für die Aufnahme von vier Behältern 1 vorgesehen. Die in den Beschichtungsstationen 3 aufgenommenen Behälter 1 werden entlang ihres Weges zwischen einer Zuführposition 4 und einer Abführposition 5 innenliegend mit einer Beschichtung versehen, welche die Barriereeigenschaften verbessert.

Die Beschichtung kann beispielsweise auf der Basis von SiOₓ gebildet sein, wobei während der Behandlung an dem Trägerrad 2 ein Umschalten zwischen verschiedenen Prozessfluiden und/oder Druckniveaus erfolgt.

Während in dem rein exemplarischen Ausführungsbeispiel der Fig. 1 an dem Trägerrad 2 18 Beschichtungsstationen 3 dargestellt sind, weist eine bevorzugte Ausgestaltung der Behälterbeschichtungsanlage 12 Beschichtungsstationen 3 auf.

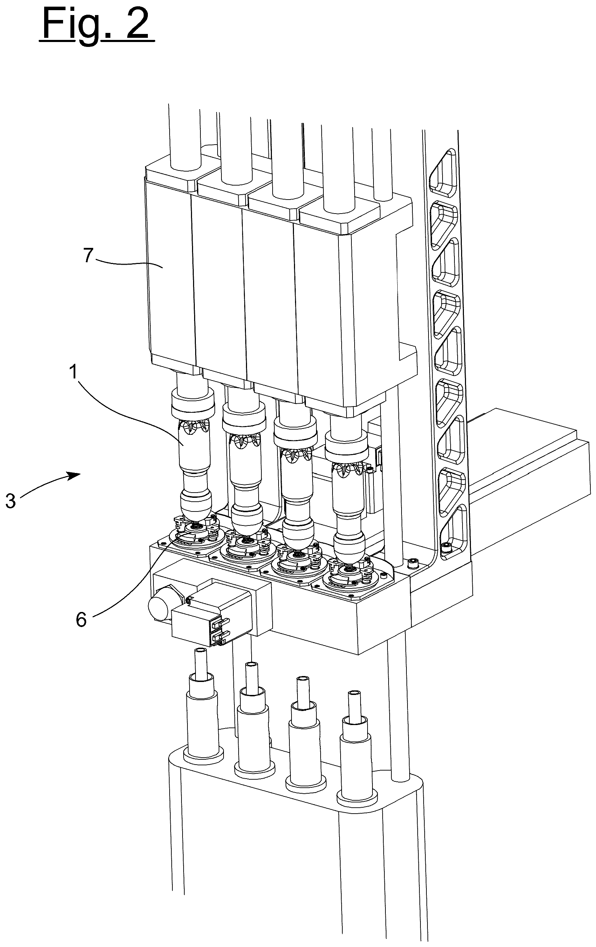

Die Fig. 2 zeigt eine Beschichtungsstation 3 in einem geöffneten Zustand. Die Beschichtungsstation 3 weist vier Behälteraufnahmen 6 auf, um Behälter 1 in Form von Getränkeflaschen mit der Öffnung nach unten aufnehmen zu können.

Bei einem Schließen der Beschichtungsstationen 3 werden die Behälter jeweils dicht in einer Beschichtungskammer 7 angeordnet, wobei Mittel zur Plasmaerzeugung durch Mikrowellen in die Behälter 1 eingefahren werden.

Nach dem Schließen der Beschichtungskammer wird ein Vakuum erzeugt, d. h. der Druck innerhalb und außerhalb der Behälter 1 wird auf ein für den Plasmaprozess geeignetes reduziertes Druckniveau gebracht.

Während eines Beschichtungsprozesses werden dann verschiedene Schritte durchlaufen.

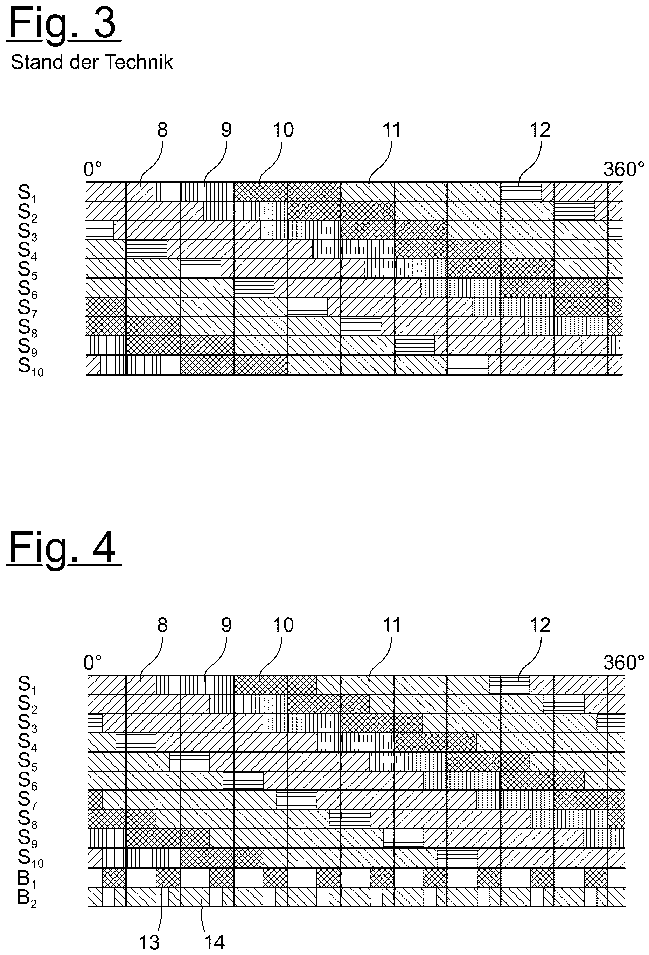

Die Fig. 3 zeigt hierzu exemplarisch ein Prozessdiagramm gemäß dem Stand der Technik für zehn Beschichtungsstationen 3, die in einer gleichen Winkelteilung an dem Trägerrad 2 befestigt sind. Auch hier ist die Anzahl der Beschichtungsstationen lediglich exemplarisch und bei einer gleichen Funktionalität auf eine beliebige Anzahl übertragbar.

Der Verlauf des gesamten Beschichtungsprozesses kann exemplarisch an einer Beschichtungsstation 3 erläutert werden, welche sich an dem Trägerrad 2 an einer ersten Position S₁ befindet. Die weiteren Beschichtungsstationen sind bei einer gleichen Winkelteilung um das Trägerrad 2 verteilt angeordnet und befinden sich an den Positionen S₂ bis S₁₀. Mit einem zeitlichen Versatz entsprechend der Winkelteilung ergibt sich an diesen weiteren Positionen S₂ bis S₁₀ die gleiche Abfolge der Schritte.

Bei den Beschichtungsstation 3 erfolgt in einem Ein- und Ausgabeschritt 8 die Aufnahme und nach dem Beschichtungsprozess die Abgabe der Behälter 1.

An die Aufnahme der Behälter 1 schließt ein Evakuierungsschritt 9 an, bei dem ein Vakuum, d. h. ein für die Plasmaerzeugung geeigneter Unterdruck innerhalb und außerhalb der Behälter nach dem Schließen der Beschichtungskammer 7 erzeugt wird. Darauf folgt ein erster Prozessschritt 10, bei dem ein erstes Prozessfluid zugeführt wird. Es schließt ein zweiter Prozessschritt 11 an, bei dem ein zweites Prozessfluid zugeführt wird. Vor dem bereits beschriebenen Ein- und Ausgabeschritt 8 ist ein Belüftungsschritt 12.

Das dargestellte Prozessdiagramm ist im Vergleich zu einer üblichen Verfahrensführung stark vereinfacht, wobei insbesondere zusätzlich zu dem ersten Prozessschritt 10 und dem zweiten Prozessschritt 11 weitere Prozessschritte - gegebenenfalls unter Zuführung eines weiteren Prozessfluids - vorgesehen sind. Die schematische, vereinfachte Ansicht gemäß der Fig. 3 ist jedoch ausreichend, um das grundlegende Prinzip der Erfindung zu verdeutlichen.

Gemäß dem Prozessdiagramm 3 zum Stand der Technik ergibt sich durch die in dem Beispiel zehn Beschichtungsstationen 3 eine Winkelteilung von 36°, welche auch durch eine vertikales Raster der Fig. 3 verdeutlicht ist. Ausgehend von einer vorgegebenen Rotationsgeschwindigkeit resultiert dann auch eine entsprechende zeitliche Aufteilung.

Bei einer detaillierten Betrachtung der Fig. 3 ergibt sich, dass der erste Prozessschritt 10 stets an genau zwei Beschichtungsstationen 3 durchgeführt ist, sodass entsprechend ein konstanter Gesamtstrom des ersten Prozessfluids zugeführt wird. Sobald die Zuführung des ersten Prozessfluids an einer Beschichtungsstation 3 endet, wird gleichzeitig eine andere Beschichtungsstation 3 zugeschaltet. Dies ist darauf zurückzuführen, dass das Prozessdiagramm auf die Winkelteilung von 36° genau angepasst ist.

In entsprechender Weise wird der zweite Prozessschritt 11 in dem exemplarischen Beispiel zeitgleich an immer drei Beschichtungsstationen 3 zugeführt, sodass das zweite Prozessfluid dann ebenfalls mit einem konstanten Gesamtstrom fließt.

Die Fig. 4 zeigt im Vergleich dazu ein erfindungsgemäßes Prozessdiagramm, bei dem die Länge des ersten Prozessschritts 10 sowie des zweiten Prozessschritts 11 variiert ist, um eine Prozessoptimierung zu erreichen. Die jeweilige Länge ist dann im Hinblick auf den Winkel und bei einer vorgegebenen Rotationsgeschwindigkeit des Trägerrades auch in Bezug auf die Dauer verändert.

Da die Länge des ersten Prozessschritts 10 und des zweiten Prozessschritts 11 nicht an die zuvor beschriebene Winkelteilung von 36° angepasst ist, wird der in seiner Länge verkürzte erste Prozessschritt 10 teilweise an nur einer der Beschichtungsstationen 3 und teilweise an zwei Beschichtungsstationen durchgeführt. Wenn der erste Prozessschritt 10 nur an einer Beschichtungsstation 3 durchgeführt wird, wird das erste Prozessfluid zur Vergleichmäßigung des Gesamtstroms in ersten Ausgleichsintervallen 13 durch einen nachfolgend weiter beschriebenen ersten Bypass B₁ geleitet.

Der zweite Prozessschritt 11 ist in der Fig. 4 dagegen im Vergleich zu der Fig. 3 verlängert, sodass der zweite Prozessschritt 11 mit der damit verbundenen Zuführung eines zweiten Prozessfluids gleichzeitig an drei oder vier der Beschichtungsstationen 3 ausgeführt wird.

Wenn der zweite Prozessschritt 11 nur an drei Beschichtungsstationen 3 ausgeführt wird, wird das zweite Prozessfluid zur Vergleichmäßigung eines Gesamtstroms des zweiten Prozessfluids in zweiten Ausgleichsintervallen 14 durch einen zweiten Bypass B₂ abgeführt.

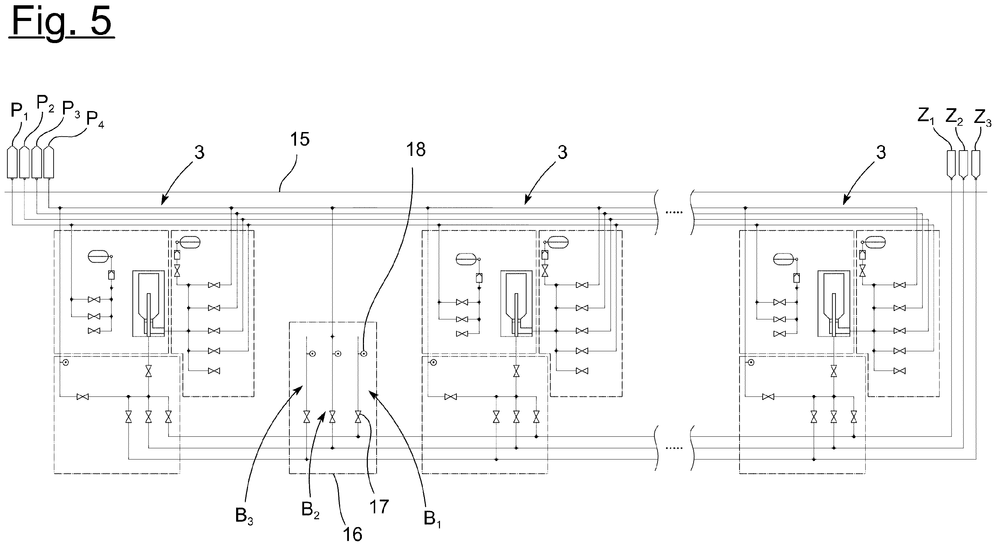

Die Fig. 5 zeigt in einem Anlagenschaubild einen Teil der Behälterbeschichtungsanlage. Dargestellt sind die Komponenten, die an dem Trägerrad 2 angeordnet sind.

Durch eine Trennlinie 15 wird der Übergang zwischen den mit dem Trägerrad 2 beweglichen Komponenten und einer nicht weiter dargestellten feststehenden Anlagenbaugruppe verdeutlicht. Über eine geeignete Drehdurchführung oder dergleichen sind eine erste Zuführleitung Z₁ für das erstes Prozessfluid, eine zweite Zuführleitung Z₂ für das zweite Prozessfluid und eine dritte Zuführleitung Z₃ für ein drittes Prozessfluid angeschlossen. Auch hier ist die Bereitstellung von drei Prozessfluiden rein exemplarisch, wobei im Rahmen der Erfindung in gleicher Weise weniger oder mehr Prozessfluide zugeführt werden können.

Alle Beschichtungsstationen 3 sind parallel zueinander in gleicher Weise an die Zufuhrleitungen Z₁ bis Z₃ angeschlossen. Für die geförderten Prozessfluide ist eine Abführung über vier Druckstufen P₁, P₂, P₃, P₄ vorgesehen.

Die einzelnen Behandlungsstationen 3 weisen eine übliche Ausgestaltung mit Ventilen und Leitungen auf, die hier nicht weiter erläutert wird.

Parallel zu den Beschichtungsstationen 3 ist des Weiteren ein Bypassmodul 16 als separate, von dem Trägerrad 2 aufgenommene Baugruppe vorgesehen. Das Bypassmodul 16 umfasst den ersten Bypass B₁, den zweiten Bypass B₂, und einen dritten Bypass B₃, welche die Zuführleitungen Z₁ bis Z₃ mit der vierten Druckstufe P₄ verbinden.

In den zuvor beschriebenen ersten Ausgleichsintervallen 13 und zweiten Ausgleichsintervallen 14 sowie dann bei drei Prozessfluiden vorgesehenen dritten Ausgleichsintervallen kann das entsprechende Prozessfluid parallel zu den Beschichtungsstationen 3 direkt zu der vierten Druckstufe P₄ abgeleitet werden. Der erste Bypass B₁, der zweite Bypass B₂ und der dritte Bypass B₃ weisen dazu jeweils ein Schaltventil 17 und eine Blende 18 auf. Die Blende 18 ist so ausgewählt, dass der Durchfluss des jeweils zugeordneten Prozessfluids dem Durchfluss an einer der Beschichtungsstationen 3 entspricht.

Wenn die Anzahl der gleichzeitig mit einem Prozessfluid beaufschlagten Beschichtungsstationen 3 um die Anzahl 1 variiert, kann durch Zu- und Abschalten des jeweiligen Bypasses B₁, B₂, B₃ ein Ausgleich erfolgen, um insgesamt einen gleichmäßigen Gesamtstrom des jeweiligen Prozessfluids zu erreichen.

### Bezugszeichenliste

- 1: Behälter
- 2: Trägerrad
- 3: Beschichtungsstationen
- 4: Zuführposition
- 5: Abführposition
- 6: Behälteraufnahme
- 7: Beschichtungskammer
- 8: Ein- und Ausgabeschritt
- 9: Evakuierungsschritt
- 10: erster Prozessschritt
- 11: zweiter Prozessschritt
- 12: Belüftungsschritt
- 13: erstes Ausgleichsintervall
- 14: zweiten Ausgleichsintervall
- 15: Trennlinie
- Z₁ - Z₃: Zuführleitung
- P₁ - P₄: Unterdruckstufe
- B₁: erste Bypass
- B₂: zweiter Bypass
- B₃: dritter Bypass
- 16: Bypassmodul
- 17: Schaltventil
- 18: Drosselelement

## Patentansprüche

1. Verfahren zum Beschichten von Behältern (1) mit mehreren jeweils zumindest einen Behälter (1) aufnehmenden Beschichtungsstationen (3), wobei den Beschichtungsstationen (3) in einem Beschichtungsbetrieb in einer zeitlichen Abfolge in zueinander versetzen ersten Zuführintervallen ein erstes Prozessfluid zugeführt wird, **dadurch gekennzeichnet, dass** das erste Prozessfluid zur Vergleichmäßigung eines Gesamtstroms in ersten Ausgleichsintervallen (13) zumindest teilweise parallel zu den Beschichtungsstationen (3) von einer ersten Zuführung (Z₁) durch einen ersten Bypass (B₁) zu einer Abführung geleitet wird.

2. Verfahren nach Anspruch 1, **dadurch gekennzeichnet, dass** die Beschichtungsstationen (3) in dem Beschichtungsbetrieb in wiederkehrenden Arbeitszyklen betrieben werden, wobei in ersten Teilzyklen n Beschichtungsstationen (3) und während der dazwischen vorgesehenen ersten Ausgleichsintervalle (13) n-1 Beschichtungsstationen (3) das ersten Prozessfluid zugeführt wird.

3. Verfahren nach Anspruch 1 oder 2, **dadurch gekennzeichnet, dass** den Beschichtungsstationen (3) in dem Beschichtungsbetrieb zusätzlich in einer zeitlichen Abfolge in zueinander versetzen zweiten Zuführintervallen ein zweites Prozessfluid zugeführt wird, wobei das zweite Prozessfluid zur Vergleichmäßigung eines Gesamtstroms in zweiten Ausgleichsintervallen (14) parallel zu den Beschichtungsstationen (3) von einer zweiten Zuführung (Z₂) durch einen zweiten Bypass (B₂) zu der Abführung oder einer zweiten Abführung geleitet wird.

4. Verfahren nach Anspruch 2 und 3, **dadurch gekennzeichnet, dass** in zweiten Teilzyklen m Beschichtungsstationen (3) und während der dazwischen vorgesehenen zweiten Ausgleichsintervalle 14 m-1 Beschichtungsstationen (3) das zweite Prozessfluid zugeführt wird.

5. Verfahren nach einem der vorangegangenen Ansprüche, **dadurch gekennzeichnet, dass** die Behälter (1) durch einen Plasmaabscheidungsprozess beschichtet werden.

6. Verfahren nach einem der vorhergehenden Ansprüche, **dadurch gekennzeichnet, dass** in dem Plasmaabscheidungsprozess ein Plasma mittels Mikrowellen erzeugt wird.

7. Behälterbeschichtungsanlage, insbesondere zur Durchführung der Verfahrens nach einem der vorangegangenen Ansprüche, mit mehreren Beschichtungsstationen (3) zur Aufnahme von jeweils zumindest einem Behälter (1), mit einer ersten Zuführung (Z₁) für ein ersten Prozessfluid, an welche die Beschichtungsstationen (3) angeschlossen sind, mit einem steuerbaren ersten Bypass (B₁) von der ersten Zuführung (Z₁) zu einer Abführung und mit einer Anlagensteuerung, wobei die Anlagensteuerung dazu eingerichtet ist, in einem Beschichtungsbetrieb das erste Prozessfluid in ersten Ausgleichsintervallen (13) parallel zu den Beschichtungsstationen (3) von der ersten Zuführung (Z₁) durch den ersten Bypass (B₁) zu der Abführung zu leiten.

8. Behälterbeschichtungsanlage nach Anspruch 7, **dadurch gekennzeichnet, dass** die Beschichtungsstationen (3) an einer umlaufenden Traganordnung, insbesondere einem Trägerrad (2), angeordnet sind.

9. Behälterbeschichtungsanlage nach Anspruch 8, **dadurch gekennzeichnet, dass** die umlaufenden Traganordnung an eine feststehendes Anlagenbaugruppe angeschlossen ist.

10. Behälterbeschichtungsanlage nach Anspruch 9, **dadurch gekennzeichnet, dass** die feststehenden Anlagenbaugruppe zumindest eine an die Abführung angeschlossene Vakuumpumpstufe und zumindest ein erstes an die erste Zuführung (Z₁) angeschlossenes Fluidaufbereitungsmodul aufweist.

11. Behälterbeschichtungsanlage nach einem der Ansprüche 8 bis 10, **dadurch gekennzeichnet, dass** der erste Bypass (B₁) an der Traganordnung angeordnet ist.

12. Behälterbeschichtungsanlage nach einem der Ansprüche 7 bis 11, **dadurch gekennzeichnet, dass** ein Bypassmodul (16) mit zumindest dem ersten Bypass (B₁) separat zu den Beschichtungsstationen (3) angeordnet ist, insbesondere an der Traganordnung.

13. Behälterbeschichtungsanlage nach einem der Ansprüche 7 bis 12, **dadurch gekennzeichnet, dass** der erste Bypass (B₁) ein Schaltventil (17) und ein Drosselelement (18) aufweist.

14. Behälterbeschichtungsanlage nach einem der Ansprüche 7 bis 13, **dadurch gekennzeichnet, dass** diese zwischen 8 und 20 Beschichtungsstationen (3) aufweist.

15. Behälterbeschichtungsanlage nach einem der Ansprüche 7 bis 14, **dadurch gekennzeichnet, dass** die Beschichtungsstationen (3) jeweils für die Aufnahme mehrerer Behälter (1), insbesondere 2 bis 4 Behälter (1), eingerichtet sind.
